Europäisches Patentamt

European Patent Office

Office européen des brevets

(19)

(11) Veröffentlichungsnummer: **0 171 466**

**A1**

(12) **EUROPÄISCHE PATENTANMELDUNG**

(21) Anmeldenummer: **84115746.4**

(22) Anmeldetag: **18.12.84**

(51) Int. Cl.⁴: **H 05 K 13/04**

(30) Priorität: **24.07.84 DE 3427275**

(43) Veröffentlichungstag der Anmeldung:
**19.02.86 Patentblatt 86/8**

(84) Benannte Vertragsstaaten:
**AT DE FR GB IT NL**

(71) Anmelder: **Siemens Aktiengesellschaft
Berlin und München Wittelsbacherplatz 2
D-8000 München 2(DE)**

(72) Erfinder: **Wilde, Rüdiger
Züricher Strasse 186
D-8000 München 71(DE)**

(54) **Verfahren zum Übertragen von Klebstoff auf einen Chipträger und Vorrichtung zur Durchfürung des Verfahrens.**

(57) Zum Aufkleben von IC-Chips auf Chipträger (6) wird ein mit Austrittsöffnungen (5) versehener und mit einem Klebstoff (3) enthaltenden Vorratsbehälter (1) verbundener Stempel (2) auf den Chipträger (6) aufgesetzt. Anschließend wird der Behälter (1) mit einem Druckluftimpuls beaufschlagt, so daß der Träger mit Klebstoff benetzt wird. Beim Abheben des Stempels reißt der Kleber; es verbleiben gleichmäßige, unverändert reproduzierbare Kleberückstände.

EP 0 171 466 A1

./...

FIG 1

FIG 3

0171466

Siemens Aktiengesellschaft            Unser Zeichen
Berlin und München                    VPA 84 P 1524 E

## Verfahren zum Übertragen von Klebstoff auf einen Chip-träger und Vorrichtung zum Durchführen des Verfahrens

Die Erfindung betrifft ein Verfahren zum Übertragen von Klebestoff aus einem Vorratsbehälter mittels eine Dosiervorrichtung auf einen Chip-Träger und eine Vorrichtung zur Durchführung des Verfahrens.

In der Halbleiterfertigungstechnik sind verschiedene Verfahren zur Kontaktierung von hochintegrierten Schaltkreisen bekannt. Dazu gehört das Aufkleben der Chips auf einen Chipträger, beispielsweise einen sog. Systemträger (Chip-Carrier) aus Kunststoff oder Keramik oder auf einen metallischen Kontaktrahmen (Lead-Frame). Der Klebstoff weist neben seiner Hafteigenschaft auch eine elektrische Leitfähigkeit auf. Er dient einerseits zur mechanischen Fixierung und andererseits zur elektrischen Kontaktierung von Chip und Chipträger. Aus Qualitätsgründen und wegen der technologisch/elektrischen Anforderungen muß dabei die Schichtdicke des Klebers gleichmäßig dick und blasenfrei ausgebildet sein.

Derzeit wird der Kleber mit einer bestimmten Viskosität in einem dem Siebdruck ähnlichen Verfahren auf den Chipträger aufgebracht. Dabei wird in einem rotationssymmetrischen Vorratsbehälter ein Rakel umlaufend bewegt. Der vor dem Rakel aufgestaute Kleber wird dabei über Öffnungen gestrichen und durch sie herausgepreßt. Durch Aufsetzen der Öffnungen auf den Chipträger wird der Kleber übertragen. Dieses Verfahren gewährleistet jedoch nicht einen gleichmäßigen Kleberabdruck in einer in der Massenfertigung geforderten Qualität.

Lg 1 Kth / 23.07.1984

Der Erfindung lag daher die Aufgabe zugrunde, ein Verfahren und eine Vorrichtung zur Durchführung des Verfaherns der o.g. Art anzugeben, mit welcher die Kleberübertragung verbessert wird.

Diese Aufgabe wird gemäß dem kennzeichnenden Teil des Anspruchs 1 bzw. 3 gelöst. Weiterbildungen der Erfindung ergeben sich aus den abhängigen Ansprüchen.

Die Erfindung beruht darauf, den Kleber über ein auf den Chipträger aufgesetztes Formteil durch einen Druckluftimpuls in Berührung mit dem Chipträger zu bringen, wobei der Chipträger gleichmäßig mit Kleber benetzt wird. Nach diesem Vorgang wird der Klebespender abgehoben. Dadurch reißt der Kleber ab und es verbleiben gleichmäßige Kleberrückstände, die von der Öffnungsgröße des Formteils und der Viskosität des Klebers abhängen. Da die Öffnungsdurchmesser und die Kleberviskosität im Verarbeitungszeitraum nahezu konstant sind, ist ein reproduzierbarer, gleichmäßiger Kleberauftrag der geforderten Güte, unabhängig von der Bauteilkonfiguration gewährleistet.

Im folgenden wird die Erfindung anhand eines Ausführungsbeispieles weiter beschrieben.

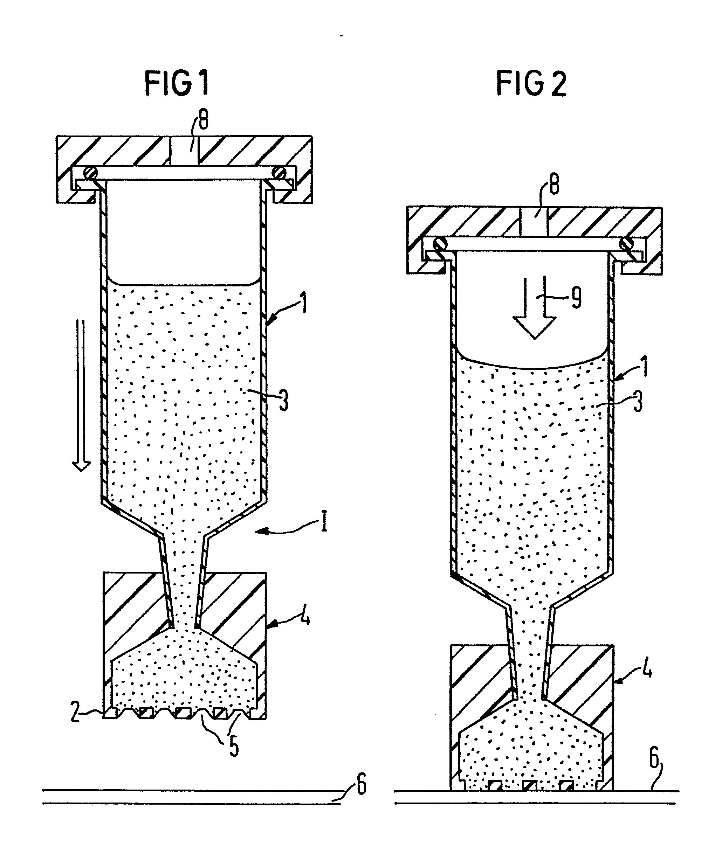

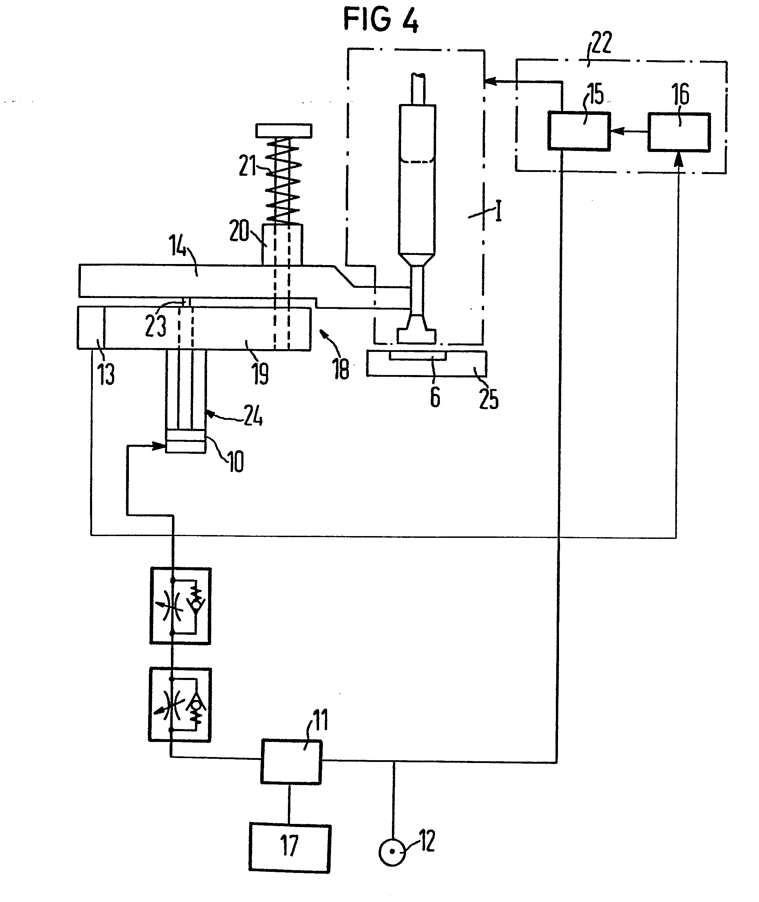

Die Figuren 1 bis 3 zeigen in drei Phasen den Kleberauftrag, Fig. 4 zeigt schematisch eine Vorrichtung zur Durchführung des Verfahrens.

Wie die Fig. 1 bis 3 zeigen, ist ein verschlossener Vorratsbehälter 1 mit elektrisch leitendem Klebstoff 3 gefüllt. Der Vorratsbehälter 1 ist mit einer Dosiervorrichtung 4 verbunden, die mit einem stempelartigen Formteil 2 versehen ist. Dieses weist Auftrittsöffnungen 5 auf einer Fläche auf, die der mit Klebstoff zu benetzenden Fläche auf einem Chipträger 6 entspricht.

In einer Ausgangsstellung nach Fig. 1 befindet sich die Dosiereinrichtung 4 bzw. der Stempel 2 oberhalb des Chipträgers 6. Zur Dosierung des Klebers wird der Stempel 2 durch eine Hubbewegung auf den Chipträger 6 aufgesetzt (Fig. 2). In dem wiedergegebenen Beispiel ist der Vorratsbehälter 1 fest mit der Dosiereinrichtung verbunden, so daß er ebenfalls diese Hubbewegung ausführt. Durch einen kurzen Druckluftimpuls (schematisch dargestellt durch Pfeil 9), der über eine Einfüllöffnung 8 auf den Kleber 3 ausgeübt wird, und der bezüglich Dauer und Druck fein dosierbar ist, wird der Kleber über die Austrittsöffnungen 5 in Berührung mit dem Chip-Träger 6 gebracht. Die Dosierung ist durch die Veränderung von vier Variablen möglich. Es kann sowohl die Zeit und der Druck des Impulses gesteuert als auch die Viskosität des Klebers und die Durchmesser der Austrittsöffnungen 5 geändert werden. Es ist auf jeden Fall eine gleichmäßige Benetzung des Chipträgers 6 sichergestellt.

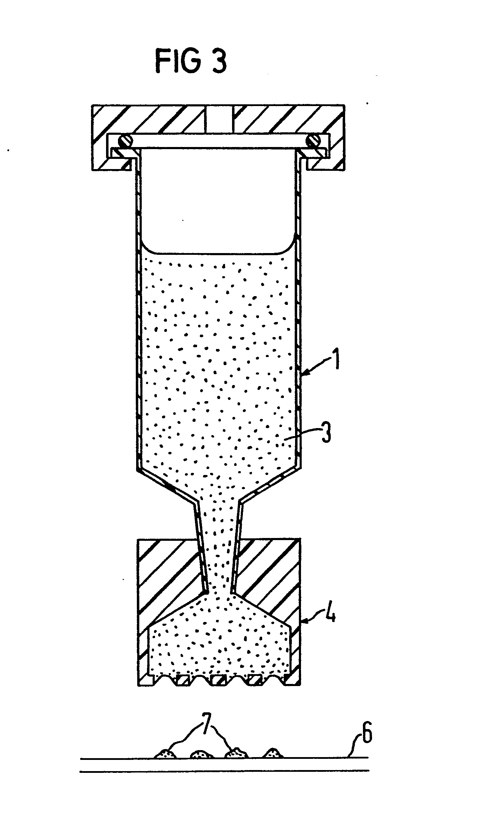

Anschließend wird die Vorrichtung in einer gegenläufigen Hubbewegung vom Chipträger 6 abgehoben. Dabei reißt der Kleber ab und hinterläßt gleichmäßige Rückstände 7 auf dem Chipträger 6 (Fig. 3).

In Fig. 4 ist die in den Figuren 1 bis 3 beschriebene Anordnung mit I bezeichnet; sie wird daher im einzelnen nicht weiter beschrieben. Die Anordnung I ist fest mit einem Oberteil 14 einer Hubvorrichtung 18 verbunden. Diese weist ferner neben einem Unterteil 19 und einer Führung 20 eine

**0171466**

Pneumatikvorrichtung 24, bestehend aus Kolben 23 und Zylinder 10, und einen Positionsfühler 13 auf.

Der Zylinder 10 und der Vorratsbehälter 1 der Anordnung I sind über eine Leitung 12 mit Druckluft beaufschlagbar. In der Zuleitung zur Pneumatikvorrichtung liegen zwei gegensinnig geschaltete von einem Maschinentaktgeber 17 gesteuerte Magnetventile 11. Vor der Vorrichtung I liegt eine Drucksteuerung 22 bestehend aus einem von einem Zeitglied 16 angesteuerten Ventil 15.

Der Chipträger 6, wird senkrecht zur Zeichenebene in einer Führung 25 bewegt. Die zum Transport erforderlichen Einrichtungen sind nicht wiedergegeben.

Im folgenden wird die Funktion dieser Vorrichtung beschrieben. Gesteuert vom Maschinentakt 17 wird der Chipträger 6  in seine Positition unterhalb der Dosierungsvorrichtung 4 transportiert. In diesem Zeitpunkt nimmt die Vorrichtung I die in Fig. 1 gezeigte Lage ein. In diese Lage wird sie dadurch gebracht, bzw. gehalten, daß das entsprechende Ventile 11 synchron mit dem Transporttakt in der Weise angesteuert wird, daß der Zylinder 10 mit Druckluft beaufschlagt wird, und durch die Bewegung des Kolbens 23 das Oberteil 14 in der Führung 20 die Hubbewegung ausführt.

Nachdem der Chipträger 6 in seine Position gebracht ist, wird der Zylinder 10 belüftet, so daß das Oberteil 14 zusammen mit der Vorrichtung I durch die Wirkung einer Feder 21 abgesenkt wird. Der Fühler 13 steuert das Zeitglied 16 an, sobald  das Oberteil 14 bzw. die Vorrichtung I die in Fig. 2 dargestellte Position erreicht hat. Dann wird das Ventil 15 mit der im Zeitglied 16, beispielsweise einem RC-Glied, festgelegten Zeitspanne geöffnet, und der Hohlraum des Vorratsbehälters 1 mit Druckluft beaufschlagt. Die anschließende Hubbewegung der Vorrichtung I erfolgt wieder durch Ansteuerung des betreffenden Rückschlagventils 11. Anschließend wird der Chipträger 6 in seine nächste Position weiterbewegt.


4 Figuren
4 Patentansprüche

**0171466**

Patentansprüche

1. Verfahren zum Übertragen von Klebstoff aus einem Vorratsbehälter mittels einer Dosiervorrichtung auf einen Chipträger, dadurch gekennzeichnet, daß ein mit Austrittsöffnungen (5) versehenes, stempelartiges, mit dem Vorratsbehälter (1) verbundenes Formteil (2) auf dem Chipträger (6) aufgesetzt wird, und daß dann der Vorratsbehälter (1) mit einem, den Kleber in der gewünschten Dosierung austreibenden Druckluftimpuls beaufschlagt wird.

2. Verfahren nach Anspruch 1, dadurch gekennzeichnet, daß der Chipträger (6) gesteuert von einem Maschinentakt unterhalb des Formteils (2) in Position gebracht wird, und daß das Formteil (2) synchron zum Maschinentakt die erforderliche Hubbewegung ausführt.

3. Vorrichtung zur Durchführung des Verfahrens nach Anspruch 1, dadurch gekennzeichnet, daß ein mit Austrittsöffnung (5) versehenes, stempelartiges, über eine Hubvorrichtung (18) auf den Chipträger (6) aufsetzbares Formteil (2) mit einem geschlossenen Vorratsbehälter (1) verbunden ist, der über eine Drucksteuerung (22) mit Druckluft beaufschlagbar ist.

4. Vorrichtung nach Anspruch 3, dadurch gekennzeichnet, daß die Hubvorrichtung (18) mit einem, ausgangsseitig mit der Drucksteuerung (22) verbundenen Positionsfühler (13) versehen ist.

FIG 1

FIG 2

FIG 3

FIG 4

### Europäisches Patentamt

## EUROPÄISCHER RECHERCHENBERICHT

## EINSCHLÄGIGE DOKUMENTE

| Kategorie | Kennzeichnung des Dokuments mit Angabe. soweit erforderlich, der maßgeblichen Teile | Betrifft Anspruch | KLASSIFIKATION DER ANMELDUNG (Int Cl 4) |
|---|---|---|---|
| A | GB-A-2 056 956 (PHILIPS) <br> * Seite 5, Zeilen 60-92; Figur 7 * | 1,3 | H 05 K 13/04 |
| | --- | | |
| A | GB-A-2 025 804 (MATSUSHITA) <br> * Seite 2, Zeilen 23-29 * | 1 | |
| | ----- | | |

| RECHERCHIERTE SACHGEBIETE (Int Cl 4) |
|---|
| H 05 K 13/00 |

Der vorliegende Recherchenbericht wurde für alle Patentansprüche erstellt

| Recherchenort | Abschlußdatum der Recherche | Prüfer |
|---|---|---|
| DEN HAAG | 15-11-1985 | TIELEMANS H.L.A. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument. das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82